## Europäisches Patentamt
## European Patent Office
## Office européen des brevets

(19)

(11) Publication number: **0 078 221**

**A2**

(12)
# EUROPEAN PATENT APPLICATION

(21) Application number: **82401971.5**

(22) Date of filing: **26.10.82**

(51) Int. Cl.³: **H 01 L 29/04**
**H 01 L 29/40**

(30) Priority: **27.10.81 US 315677**

(43) Date of publication of application:
**04.05.83 Bulletin 83/18**

(84) Designated Contracting States:
**DE FR GB IT NL**

(71) Applicant: **FAIRCHILD CAMERA & INSTRUMENT CORPORATION**
**464 Ellis Street**
**Mountain View California 94042(US)**

(72) Inventor: **Vora, Madhukar B.**
**110 Lansberry Court**
**Los Gatos California 95030(US)**

(74) Representative: **Chareyron, Lucien et al,**
**Schlumberger Limited Service Brevets 42, rue Saint-Dominique**
**F-75340 Paris Cedex 07(FR)**

(54) Polycrystalline silicon diode with metal silicide contact.

(57) A method of fabricating a diode in an integrated circuit structure includes the steps of depositing a layer of N conductivity type polycrystalline silicon 12 on an underlying insulating substrate 10, depositing a layer of metal silicide 15 on the N type layer 12, forming a layer of insulating material 18 on top the metal silicide 15, providing an opening 20 to the N type layer through the insulating layer 18 and the metal silicide 15, forming insulating material 18 over the edges of the metal silicide 15 in the opening 20, and depositing a layer of P conductivity type polycrystalline silicon 22 across the opening 20 in contact with the N conductivity type polycrystalline silicon 12. An ohmic connection to the layer of metal silicide type provides a connection to the N type region.

A diode in an integrated circuit includes a substrate 10, a first layer of N type polycrystalline silicon 12 deposited on the substrate, a layer of electrically conductivity material 15 deposited on the N type polycrystalline silicon 12 except where the diode is desired, and a region of P conductivity type polycrystalline silicon 22 deposited in contact with the N conductivity type polycrystalline silicon 12 in the selected region, and everywhere separated from the layer of electrically conductive material 15 by insulating material 18.

FIG. 6

EP 0 078 221 A2

POLYCRYSTALLINE SILICON DIODE
WITH METAL SILICIDE CONTACT

## BACKGROUND OF THE INVENTION

### Field of the Invention

This invention relates to integrated circuits and methods of manufacturing them, and in particular to a polycrystalline silicon diode having a metal silicide contact, and a method of fabricating it.

### Description of the Prior Art

Polycrystalline silicon diodes are known in the integrated circuit arts, and have been formed by fabricating P conductivity type polycrystalline silicon in contact with N conducitivity type polycrystalline silicon. One prior art technique for fabricating polycrystalline silicon diodes is to deposit a first conductivity type polycrystalline silicon layer on an underlying substrate and then deposit an overlying opposite conductivity type polycrystalline layer on the underlying layer. Electrical connections may then be made using well-known techniques.

This prior art approach is undesirable because polycrystalline silicon has a sheet resistivity which is typically greater than 20 ohms per square, and it is desirable to reduce the resistivity to on the order of less than 4 ohms per square. Furthermore, such prior art structures require a relatively large area for the diode, and require several masking operations.

### Summary of the Invention

A general object of this invention is to provide a diode for an integrated circuit structure, and a method of making the diode.

In one embodiment an integrated circuit structure fabricated according to this invention includes a substrate; a first layer of first conductivity type material disposed on the substrate; a second layer of electrically conductive material disposed on the first layer except in a selected region; and an opposite conductivity type material disposed in contact with the first layer in the selected region, and everywhere separated from the second layer by insulating material.

In one embodiment the diode of this invention is fabricated by depositing a first layer of first conductivity type material on an underlying substrate; depositing a second layer of electrically conductive material on the first layer; providing an opening to the first layer through the second layer; forming insulating material over the second layer and on the edges of the second layer in the opening; and depositing a third layer of opposite conductivity type material across the opening in contact with the first layer in the opening.

Brief Description of the Drawings

Figure 1 is a cross-sectional view of an integrated circuit structure.

Figure 2 is subsequent cross-sectional view after formation of an opening in the structure shown in Figure 1.

Figure 3 is subsequent cross-sectional view after oxidizing the surfaces of the opening.

Figure 4 is subsequent cross-sectional view after removal of a portion of the oxide from the opening.

Figure 5 is subsequent cross-sectional view after formation of the diode of this invention.

Figure 6 is subsequent cross-sectional view after fabrication of openings for electrical contacts to the diode.

Figure 7 is top view of the structure shown in Figure 6.

## Description of the Preferred Embodiments

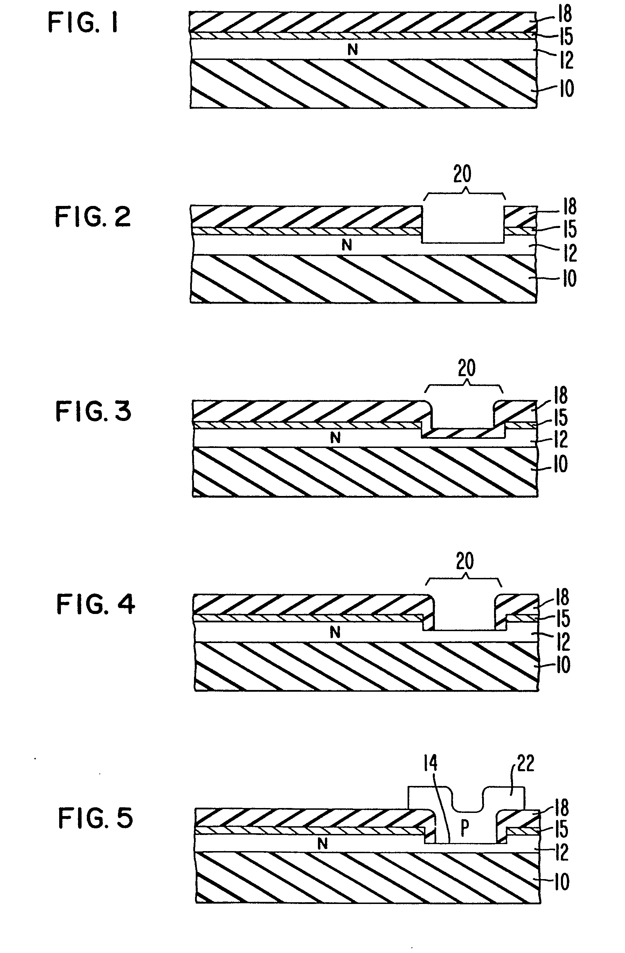

Figure 1 is a cross-sectional view of an integrated circuit structure which may be fabricated using known process technology. In the preferred embodiment the structure of Figure 1 is a fabricated by depositing N conductivity type polycrystalline silicon 12 on an underlying substrate 10. Polycrystalline layer 12 may be deposited as doped polycrystalline silicon to a thickness of 6000 Angstroms using chemical vapor deposition or may be deposited as relatively pure polycrystalline silicon which is subsequently doped by ion implantation, diffusion or other well known techniques. In the preferred embodiment phosphorous is used to dope layer 12 to a concentration of $10^{20}$ atoms per cubic centimeter.

On the upper surface of polycrystalline silicon layer 12, a layer of metal silicide 15 is deposited using chemical vapor deposition. In the preferred embodiment metal silicide layer 15 is approximately 1000 Angstroms thick. The use of a metal silicide is desirable because of the excellent electrical connection which will result between the silicide layer 15 and the underlying polycrystalline silicon 12. Any electrically conductive silicide may be used, however, refractory metal silicides are preferred because of their ability to withstand subsequent high temperature processing operations to which the integrated circuit may be subjected.

On the upper surface of metal silicide 15 a layer of silicon dioxide 18 is formed. In the preferred embodiment silicon dioxide layer 18 is created by heating the underlying structure to a temperature of 1000°C in steam for 60 minutes to create a layer approximately 3000 Angstroms thick. As will be evident from the description accompaning Figures 2 through 7, the thickness of layer 18 need only be sufficient to assure that subsequently deposited layers of material on layer 18 will be electrically isolated from silicide layer 15.

Although in Figure 1 a relatively thick layer of silicon dioxide 10 is used as a substrate, any material upon which polycrystalline silicon 12 may be deposited could be employed as the substrate. If an insulating material such as silicon dioxide is employed, the diode, or other circuit elements fabricated above silicon dioxide layer 10, will be electrical isolated from any structure beneath silicon dioxide layer 10. In some embodiments of the invention, however, this electrical isolation may not be desirable, and hence other materials may be employed as a substrate. In other embodiments of the invention, silicon dioxide layer 10 itself will be an insulating layer formed atop an integrated circuit containing other desired electronic components.

As shown in Figure 2 an opening 20 is next made in a desired location through at least silicon dioxide 18 and metal silicide 15. This may be accomplished using well known photolithographic processes in conjunction with any desired chemical or plasma etching process. In the preferred embodiment a plasma containing carbon tetrafluoride ($CF_4$) is used to etch through layer 18, while carbon tetrachloride ($CCl_4$) is used to etch through layer 15. As shown in Figure 2, to assure that all of the metal silicide 15 is removed from within opening 20, the etching process is allowed to continue for a slightly longer time than is necessary to remove all of the silicide 15. This results in a slight etching of underlying polycrystalline silicon 12 as shown, and assures that materials subsequently deposited in opening 20 will contact polycrystalline silicon 12.

As shown in Figure 3, insulating material is then formed in opening 20 across the surface of polycrystalline silicon 12 and over the exposed edges of metal silicide 15. In the preferred embodiment this is accomplished by heating the structure to a temperature of 1000°C for a period of 10 minutes to create approximately 1000 Angstroms of silicon dioxide 18 in the bottom of the opening 20. It is essential to the subsequent fabrication steps described in conjunction with Figures 4 through 7 that insulating material 18 be formed over the sides of opening 20 to cover the exposed edges of silicide 15.

As next shown in Figure 4, an anisotropic etching process, for example, plasma etching using carbon tetrafluoride, is employed to remove the silicon dioxide layer 18 from the bottom of opening 20.  To prevent subsequently deposited layers from forming electrical connections to silicide 15, the silicon dioxide 18 on the edges of layer 15 is not removed.

A layer of polycrystalline silicon 22 is next deposited across the upper surface of the integrated circuit structure and suitably defined using well-known photolithographic and etching processes as shown in Figure 5.  In the preferred embodiment the polycrystalline silicon layer 22 is deposited using chemical vapor deposition to a thickness of 6000 Angstroms. The layer may be deposited as polycrystalline silicon doped P conductivity type, or may be deposited as relatively pure polycrystalline silicon and subsequently doped P conductivity type by ion implantation, diffusion, or other processes.  In the preferred embodiment boron is used to dope polycrystalline silicon 22 to an impurity concentration of $10^{19}$ atoms per cubic centimeter.  A PN junction 14 is created by the interface between P type polycrystalline silicon 22 and N type polycrystalline silicon 12.

Next, a layer of silicon dioxide or other insulating material 25 is formed across the upper surface of the integrated circuit structure.  In the preferred embodiment 3000 Angstroms of silicon dioxide 25 are formed by heating the integrated circuit structure in steam to a temperature of 1000°C for 60 minutes. The layer of silicon dioxide is then selectively removed using known photolithographic and etching techniques.  An opening 27 is created to P type region 22 and an opening 28 is created to metal silicide 15.  Ohmic connections (not shown) may be then be provided through openings 27 and 28 to P type region 22 and metal silicide 15.  Fabrication of such ohmic connections is well known, and may utilize any conductive material, for example, aluminum.  The contact through opening 28 provides an ohmic connection to the N conductivity type portion of PN junction 14, because silicide 15 provides a low resistance connection to polycrystalline silicon 12.

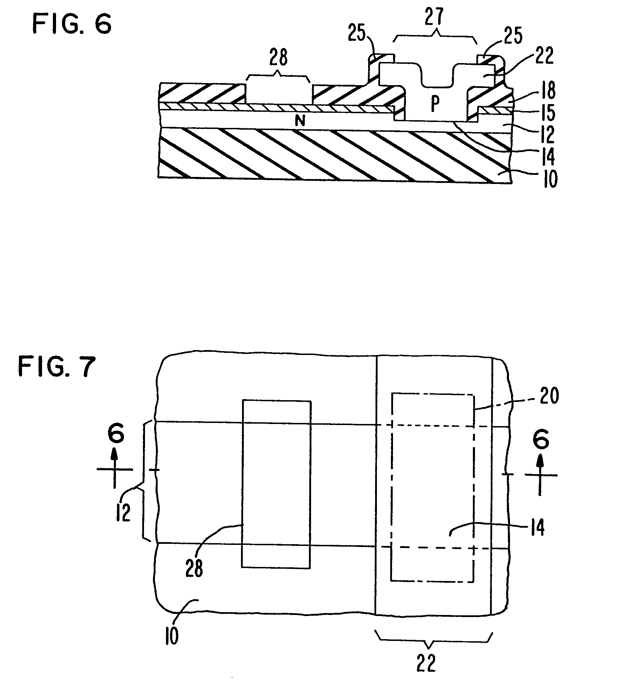

Figure 7 is a top view of the structure shown in Figure 6. Figure 7 illustrates how the diode 14 of this invention may be fabricated at the intersection of two polycrystalline silicon lines 12 and 22. Figure 7 illustrates how only a single mask to define opening 20 (also shown in Figure 2) is necessary to fabricate the diode, with an additional mask being used to define the contact openings 27 and 28. Opening 27 is not shown in Figure 7.

Because the structure depicted is fabricated on an underlying silicon dioxide layer or substrate 10, each of openings 27 and 28 may be made wider than the width of line 12 as shown in Figure 7. The enlarged sizes of the openings 27 and 28 simply cause any deposited material to contact either the desired regions or to harmlessly contact underlying silicon dioxide. The use of a single mask and self-alignment techniques permit fabrication of an exceptionally compact diode.

Although a preferred embodiment of the diode of this invention is described, together with a method of manufacturing it, it will be apparent to those skilled in the art that numerous variations and modifications can be made without departing from the scope of the invention as set forth in the appended claims. For example, opposite conductivity type polycrystalline silicon layers may be substituted, electrically conductive material other than metal silicide may be employed, or other types of substrate may be used.

WHAT IS CLAIMED IS:

1. A method of fabricating a diode characterized by:

depositing a first layer of first conductivity type material on an underlying substrate;

depositing a second layer of electrically conductive material on the first layer;

providing an opening to the first layer through the second layer;

forming insulating material over the second layer and on the edges of the second layer in the opening; and

depositing a third layer of opposite conductivity type material across the opening in contact with the first layer in the opening.

2. The method of claim 1 characterized in that the first layer and the third layer comprise polycrystalline silicon.

3. The method of claim 1 or 2 characterized in that the second layer comprises a metal silicide.

4. The method of any previous claim characterized in that the insulating material comprises silicon dioxide.

5. The method of any previous claim characterized in that the substrate comprises silicon dioxide.

6. The method of any previous claim characterized in that the steps of depositing a first layer and depositing a third layer comprise chemical vapor deposition.

0078221

7.    The method of any previous claim characterized in that the step of depositing a second layer comprises chemical vapor deposition.

8.    The method of any previous claim characterized in that the step of providing an opening comprises etching through the second layer to the first layer.

9.    The method of any previous claim characterized in that the step of forming insulating material comprises oxidizing the second layer.

10.    The method of any previous claim characterized in that immediately preceding the step of providing an opening, a step of fabricating a layer of silicon dioxide on the second layer is performed.

11.    The method of claim 10 characterized in that the silicon dioxide is formed by oxidation.

12.    The method of claim 10 or 11 characterized in that the step of forming insulating material comprises thermally oxidizing the second layer to form a layer of silicon dioxide.

13.    The method of claim 12 characterized in that the step of forming insulating material includes forming insulating material across the surface of the first layer of the opening.

14. The method of claim 13 characterized in that following the step of forming insulating material a step of removing insulating material from the bottom of the opening is performed.

15. The method of claim 14 characterized in that the step of removing insulating material from the bottom of the opening comprises plasma etching.

16. The method of claim 14 or 15 characterized by the step of providing an opening to the opposite conductivity type material and the electrically conductive material.

17. The method of claim 16 characterized by the step of fabricating ohmic connections to the opposite conductivity type material and the electrically conductive material.

18. An integrated circuit structure characterized by:
a substrate;
a first layer of first conductivity type material disposed on the substrate;
a second layer of electrically conductive material disposed on the first layer except in a selected region; and
an opposite conductivity type region of material disposed in contact with the first layer in the selected region, and everywhere separated from the second layer by insulating material.

19. The structure of claim 18 characterized in that each of the first layer and the opposite conductivity type region comprise polycrystalline silicon.

20.  The structure of claim 18 or 19 characterized in that the second layer comprises a metal silicide.

21.  The structure of claim 18, 19 or 20 characterized in that the insulating material comprises silicon dioxide.

22.  The structure of any one of claims 18-21 characterized in that the substrate comprises silicon dioxide.

23.  The structure of any one of claims 18-22 characterized by a first ohmic connection to the second layer and a second ohmic connection to the opposite conductivity type region.

24.  The structure of any one of claims 18-23 characterized in that the first layer comprises N conductivity type polycrystalline silicon and the opposite conductivity type region comprises P type conductivity polycrystalline silicon.

25.  The structure of any one of claims 18-23 characterized in that the first layer comprises P conductivity type polycrystalline silicon and the opposite conductivity type region comprises N conductivity type polycrystalline silicon.

1/2

FIG. 1

FIG. 2

FIG. 3

FIG. 4

FIG. 5

FIG. 6

FIG. 7